(19) Europäisches Patentamt
European Patent Office
Office européen des brevets

(11) Publication number: **0 396 252 A1**

# (12) EUROPEAN PATENT APPLICATION

(21) Application number: 90303406.4

(51) Int. Cl.⁵: C23C 18/22, C23C 18/16

(22) Date of filing: 30.03.90

(30) Priority: 05.05.89 US 347859
14.08.89 US 393433

(43) Date of publication of application:
07.11.90 Bulletin 90/45

(84) Designated Contracting States:
AT BE CH DE DK FR GB IT LI NL SE

(71) Applicant: MORTON INTERNATIONAL, INC.
110 North Wacker Drive
Chicago, Illinois 60606-1560(US)

(72) Inventor: Krulik, Gerald A.
25142 Barents Street
Laguna Hills, California 92653(US)
Inventor: Duffy, John K.
2415 Appian Road
Carlsbad, California 92008(US)

(74) Representative: Bankes, Stephen Charles Digby et al
BARON & WARREN 18 South End Kensington
London W8 5BU(GB)

## (54) Electrolytic regeneration of alkaline permanganate etching bath.

(57) Method and apparatus for generating permanganate ions electrolytically in an aqueous solution containing manganate ions. The solution is electrolyzed using an anode (12) to cathode (14) wetted area ratio of more than 5 to 1, applying sufficient voltage to generate hydrogen at the cathode (14) instead of reconverting permanganate ions to manganate ions.

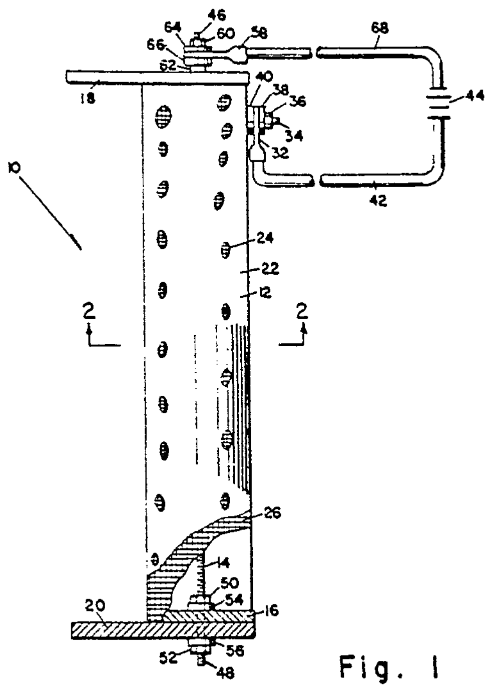

Fig. 1

EP 0 396 252 A1

# ELECTROLYTIC REGENERATION OF ALKALINE PERMANGANATE ETCHING BATH

## TECHNICAL FIELD

The present invention relates to electrolytic conversion of manganate ions ($MnO_4^{-2}$) to permanganate ions ($MnO_4^{-1}$) in an alkaline aqueous permanganate solution. The particular application is regeneration of the hydroxyl and permanganate ions of an aqueous permanganate oxidizing bath during or following depletion of those constituents by the oxidation of materials immersed in the bath.

## BACKGROUND OF THE INVENTION

An alkaline aqueous permanganate bath can be used to oxidize a wide variety of materials. For example, organic materials can be oxidized in such a bath to form carbonate ion which is soluble in water. Using the bath depletes it by reducing permanganate ions to manganate ions and solid manganese dioxide. The bath constituents and temperature are so maintained as to minimize the irreversible precipitation of manganese dioxide. The principal ion generated as a result of depletion of permanganate ion is thus manganate ion.

In the process described in U.S. Patent No. 4,698,124, issued to Krulik and hereby incorporated herein by reference, epoxy resin is removed from a printed circuit board using a permanganate solution. This process is called desmearing or etching. The bath must be replenished with permanganate and hydroxyl ions and depleted of manganate ions to remain useful for etching.

The previously incorporated patent describes chemical regeneration of the permanganate bath by periodically adding a strong oxidizing agent (such as an alkali metal hypochlorite or monopersulfate) to the bath to oxidize manganate and manganese dioxide to permanganate. This is a commercially useful solution to the problem, and provides a bath that can be regenerated almost indefinitely. One disadvantage is that by-products of regeneration can build up in the bath, eventually requiring partial or complete replacement of the bath. Another disadvantage is that chemicals must be added and solution constituents must be monitored frequently to maintain the bath.

Electrolytic oxidation of manganate, manganese dioxide, manganese metal or other reduced forms of manganese to produce permanganates is well known, but has not been employed commercially except as described below due to complications inherent in the process.

Generating permanganate by electrolytically oxidizing manganate is difficult because the reaction goes forward at the anode and backward at the cathode at about equal rates. Thus, little forward progress is observed when manganate baths are electrolyzed using electrodes having approximately equal wetted areas. Much of the prior art has been directed to concurrent generation of permanganate and manganate from species having lower oxidation states, rather than generation of permanganate from manganate in permanganate etching baths, so this equilibrium, undesired here, has not presented a problem.

A second problem with the regeneration of permanganate baths has been the need to regenerate ions in the presence of the other bath constituents at the bath temperature, particularly when electrolytic regeneration is to occur while the bath is in use.

Henke, et al., "Electrolytic Preparation of Sodium Permanganate", J.Phys. Chem. 24:608 (1920) teaches the oxidation of a ferromanganese anode to produce sodium permanganate. Several distinctions from the present process are Henke's use of an anode:cathode wetted area ratios of only 4.5:1 (with no appreciation that a higher ratio would be useful -- see page 609); his employment of an analytical method for measuring permanganate levels which does not distinguish between manganate and permanganate (pages 609-610); his teaching that only 10 grams per liter of sodium hydroxide should be present to avoid concurrent generation of manganate ion (p. 611 data), page 614, first paragraph); and his teaching that manganate and manganese dioxide are formed at an elevated temperature such as 65 °C (about 150 °F), so elevated temperatures should be avoided (page 612).

Wilson et al., "An Electrolytic Process for the Production of Sodium Permanganate from Ferromanganese", Trans. Am. Electrochem. Soc. 35:371 (1919), differs from the present process by employing exchangeable anodes and cathodes inherently having equal nominal areas, using sodium carbonate as an anolyte in a two-cell apparatus, forming no more than 8% permanganate (pages 380, 382), and preferably operating at 20 °C (page 381).

## SUMMARY OF THE INVENTION

The invention is an improved process for regenerating an alkaline permanganate oxidizing bath by converting manganate to permanganate.

One feature of the invention is the use of electrolysis to convert manganate ions to permanganate ions. This process can be used periodically or continuously, and can be carried out while the bath is being used for oxidation. The need to add chemicals and analyze the chemical constitution of the bath is thus minimized. Also, the rate of build-up of nonfunctional species which will ultimately require replacement of the bath is reduced.

A second feature of the invention is the use of an anode having a wetted area more than five times as great, preferably more than twelve times as great, as the wetted area of the cathode. The advantage of this feature is that permanganate is generated at the anode faster than it is decomposed elsewhere in the cell.

A third feature of the invention is operation of the process at a high enough cathode potential to generate hydrogen gas and hydroxyl ions by the electrolysis of water. Since hydroxyl ions are depleted when the bath is used for oxidation, the present process replenishes lost hydroxyl ions electrolytically, reducing the need to add a chemical source of hydroxide to the bath. The formation of hydrogen also competes with reduction of permanganate ions to manganate ions at the cathode, reducing the rate of this undesired reverse reaction.

## BRIEF DESCRIPTION OF DRAWINGS

Figure 1 is a diagrammatic side elevation of an electrode useful for practicing the present invention partly cut away and sectioned to show interior details.

Figure 2 is a section taken along line 2 -- 2 of Figure 1.

The following reference characters are used herein.

10 electrode assembly
12 anode
14 cathode rod
16 spacer
18 end plate
20 end plate
22 copper sheet
24 perforation
26 screen
28 edge (of 22 + 26)
30 edge (of 22 + 26)
32 terminal
34 bolt
36 nut
38 washer
40 washer
42 conductor
44 power source (DC)
46 end (of 14)
48 end (of 14)
50 nut
52 nut
54 washer
56 washer
58 terminal
60 nut
62 nut
64 washer
66 washer
68 conductor

DETAILED DESCRIPTION OF THE INVENTION

Permanganate oxidizing baths can contain different constituents in different proportions, depending upon the starting materials chosen. desirable bath characteristics for a particular application, and the extent to which the bath has been depleted of permanganate through use.

Two baths which are contemplated herein have the characteristics tabulated in Table 1. The present process can be used with a variety of alkaline permanganate baths, providing the bath is maintained under conditions which will not precipitate a substantial amount of manganese dioxide.

The electrolytic regeneration apparatus contemplated herein is desirably a single cell consisting of a tank or vessel, an anode, a cathode, and a source of electromotive force electrically connected between the anode and cathode.

The electrolytic cell can be set up in the working vessel in which the bath is used. The electrolytic cell can also be set up in a separate vessel, through which part or all of the bath is periodically or continuously circulated from its working vessel. In either case, the cell vessel should be resistant to alkali, manganate, permanganate, and elevated bath temperatures. A plastic vessel is not favored because it will react with permanganate ions. The vessel is desirably made of glass, titanium, stainless steel, nickel, nickel plated metal (such as steel), or other suitable alloys or materials.

The anode does not participate chemically in regeneration; it is merely a conduit for electron transfer. Therefore, any conductive material which resists chemical attack by the bath and electrolysis is useful as an anode. Since the anode should have a wetted area much greater than the cathode's wetted area, it is convenient to use at least part of the interior wall of the cell vessel as the anode. Nickel-plated steel or copper, titanium, precious metals (such as platinum), or other suitable materials can be used as the anode.

The choice of cathode material is less limited because electrolysis tends to reduce metals at the cathode. However, the cathode material must also resist oxidation by the bath. Any of the materials useful for anodes, as well as copper, steel, and plated overcoat deposits, can be used as the cathode. Since the cathode is relatively small, it can be configured and placed so it does not interfere with use of the bath.

The electrodes and cell vessel are so constructed that the ratio of the wetted area of the anode to the wetted area of the cathode is more than 5:1, preferably more than 12:1, more preferably more than 30:1, most preferably more than 60:1. The upper limit of this ratio is dictated by the need for reasonably compact apparatus having a large enough cathode so electrolysis proceeds at a reasonable rate. Expressed another way, the current density at the cathode is at least 5 times as great, and preferably at least 12, 30, or 60 times as great, as the current density at the anode during electrolysis. The cell is desirably constructed so small variations of the bath level due to evaporation, drag out, and the like do not appreciably vary the ratio of wetted areas of the anode and cathode.

As is well known in the electrochemical art, the effective wetted area of an electrode can differ from its nominal wetted area due to the configuration or placement of the electrode within the cell, corrosion, or other factors. "Wetted area" as used herein refers to the effective wetted area of an electrode.

Figures 1 and 2 illustrate an electrode assembly 10 suitable for carrying out the present invention. Assembly 10 comprises a cylindrical shell anode 12 and a cathode rod 14 supported by separated by spacers such as 16 (shown in section) and end plates 18 and 20 (the latter shown in section). The spacers and end plates are rigid TEFLON (trademark of E.I. duPont de Nemours & Co., Wilmington, Delaware, for polytetrafluoroethylene).

Anode 12 is a rectangular sheet 22 of electroless nickel-plated copper foil, having regularly spaced one inch (25 mm) diameter perforations such as 24. Sheet 22 is lined with a substantially coextensive fine mesh electroless nickel-plated copper screen 26 and rolled so its meeting edges 28 and 30 overlap. Edges 28 and 30 are joined with a series of axially spaced rivets 32 to form a self-supporting cylinder. Rivets 32 also secure screen 26 mechanically and electrically to sheet 22. A positive terminal lug 32 is secured to anode 12 by bolt 34 (passing through perforations of sheet 22 and screen 26), nut 36, and washers 38 and 40. Lug 32 is connected by electric conductor 42 to DC electric power source 44. In this embodiment anode 12 is 4 inches (10 cm) in diameter, and edges 28 and 30 are 24 inches (61 cm) long.

Cathode rod 14 is a 3/8 inch (9.5 mm) diameter copper rod, having threaded ends 46 and 48. The portion of rod 14 passing through spacer 16 and end plate 20 is shown in section. Spacer 16, plate 20, and rod 14 are secured together by nuts 50 and 52 threaded on rod 14 and washers 54 and 56. A similar arrangement, not fully shown, secures rod 14, plate 18, and a spacer together. Terminal 58 is mechanically and electrically connected to rod 14 by nuts 60 and 62 (threaded on end 46) and washers 64 and 66. Terminal 58 receives electrical power from power supply 44 via conductor 68.

The anode to cathode wetted area ratio of electrode assembly 10 is approximately 21:1, regardless of the depth of immersion, because the anode area added by screen 26 approximately equals the anode area

lost to perforations such as 22. The contribution of nuts and washers 50, 52, 54, and 56 and end 48 to cathode area is negligible.

Other electrode constructions can be readily devised by one of ordinary skill in the art.

The permanganate regeneration cell is conveniently operated as follows. The source of electromotive force is a conventional DC power supply. The electrode potentials must be maintained at a sufficient magnitude and polarity to allow the electrode reactions to proceed. The desired anode reaction:

$MnO_4^{-2} \rightarrow MnO_4^{-1} + e$

has a theoretical potential of about + 0.5 volts versus a hydrogen electrode under the conditions of concentration and temperature specified for baths 1 or 2 above. The anode positive potential should be maintained at a greater magnitude than this to allow electrolysis to proceed. However, to avoid wasting electricity by electrolyzing water at the anode to generate oxygen gas:

$2\ H_2O \rightarrow 4\ H^+ + O_2 + 4e$

the anode potential should not be too high.

The desired cathode reaction is:

$2H_2O + 2e \rightarrow H_2 + 2\ OH^-$

and the unavoidable cathode reaction to be minimized is the reverse of the manganate-to-permanganate anode reaction specified above. The desired cathode reaction will take place only if the cathode potential, versus a hydrogen electrode, has a greater magnitude than about -0.8 volts. Therefore, the proper reactions will proceed if the anode-to-cathode potential difference is at least about 2 volts. The preferred potential difference is at least about 4 volts.

Should the bath be electrolyzed at a different temperature or with different concentrations of constituents (including recharging a more completely depleted solution), different electrode potentials might be necessary. When conditions have changed, the new optimal potential can be determined by increasing the potential until formation of a green film of manganate on the cathode is not observed and a substantial quantity of hydrogen gas is being generated at the cathode.

The bath must be replenished to replace any evaporation losses. This can be done without constantly evaluating the existing bath composition, providing one has determined, by practical experience, how much of the loss is evaporation of water and how much is drag out of the complete bath. With that knowledge, one can compensate for water losses by adding deionized water and for drag out by adding bath components in the proportions as in the optimized bath. Finally, the bath might require periodic filtration, when used to etch or desmear circuit boards, to remove insoluble manganese dioxide by-products.

EXAMPLE 1 (comparative): No Regeneration

Three liters of a bath nominally containing about 160 grams per liter of sodium permanganate and about 40 grams per liter of sodium hydroxide in deionized water was passed through a paper filter to promote manganate formation, thereby depleting the permanganate to some degree. 200 ml of 50% sodium hydroxide in water was added and that mixture allowed to stand to further deplete the solution.

Nickel electrodes were prepared by electroplating copper-plated electrodes in nickel sulfamate at a current density of 25 amperes per square foot (2.3 amperes per square meter) for thirty minutes.

The bath and electrodes were placed in a glass beaker so that the anode and cathode had equal effective wetted areas of about 0.25 square feet (232 $cm^2$). Stirring was provided and electrolysis was conducted at room temperature with the starting composition and results tabulated in the first block of data in Table 2. Water was added as necessary to maintain the liquid level at the 3.5 liter mark of the beaker during the experiment. (Throughout these examples the manganate and permanganate concentrations do not add up to a constant number because different analytical methods were used and were not reconciled.) The potential difference between the anode and the cathode was 1.5 volts, the current was 10 amperes, and no permanganate or hydroxyl ions were generated after four hours.

The next day the concentration of hydroxyl ions was increased to 160 g/l by adding sodium hydroxide and electrolysis was restarted at room temperature. The results are recorded in the second block of data in Table 2. A net degeneration of permanganate and a negligible change of hydroxyl ion concentration were observed. This illustrates that an anode to cathode potential difference of about 1.5 volts and an anode to cathode wetted area ratio of 1:1 will not regenerate permanganate from manganate under the other conditions of the experiment.

After the second run of Table 2 was completed, the electrolytic cell was examined. A green colored film was found to have splashed up on the sides of the beaker above the cathode. This suggested that manganate ion was produced at the cathode.

## EXAMPLE 2

In this example the anode to cathode ratio, current, and voltage were increased. (The ratio of wetted areas of electrodes was changed by replacing electrodes or by raising and lowering the electrodes in the bath.) Also, a relatively higher proportion of sodium hydroxide was present. A permanganate oxidizing bath was prepared as in example 1 and depleted of permanganate ions by filtering it through filter paper. The initial bath had the composition set forth under time "0" in the first block of data in Table 3. The proportion of sodium hydroxide was substantially above that for the typical oxidizing baths of Table 1. A substantially higher voltage and amperage was used, and initially the bath was highly depleted, as indicated by the higher proportion of manganate ions (83 grams per liter) than permanganate ions (50 grams per liter) in the solution. The anode was a bank of three nickel plated plates of the type described in example 1, electrically connected together. The cathode previously used was replaced with a stainless steel bar.

Looking at the first block of data in table 3, a 15:1 ratio of anode to cathode areas, a 5.8 volt potential difference between the anode and cathode, a high proportion of sodium hydroxide, and a higher temperature than before decreased the proportion of manganate and increased the proportion of permanganate. Thus, regeneration occurred. When a sample was pipetted after 1 hour for analysis, crystals were formed in the pipette, thus causing some difficulty in obtaining data and some uncertainty as to the numerical values of the data.

After 4 hours, the anode and cathode potentials were measured versus a saturated calomel electrode (SCE). The anode potential was 1.5 volts versus SCE and the cathode potential was minus 3.4 volts versus SCE. These measurements suggest that the voltage data collected was somewhat high, probably due to losses in the wires leading to the electrodes. Comparing the 4 hour data to the 5 1/2 hour data, it will be seen that a particularly large increase in sodium hydroxide concentration seems to coincide with degeneration of part of the permanganate ions present. The combination of the high temperature and high sodium hydroxide concentration in this experiment apparently interfered with regeneration.

On the following day, the cathode was cleaned to remove material believed to be manganese dioxide. Some of the permanganate was degraded to manganate at the beginning of the test. The anode to cathode ratio was reduced to 12:1, and after 2 hours was briefly reduced to less than 12:1. After 1 hour, the voltage was briefly reduced from 8 volts (anode to cathode) to 2 volts. At the same time the amperage fell from 14 to 6 amperes. The results of this run are reported in the second block of data in Table 3. There was only slight regeneration of permanganate and a corresponding reduction in manganate ion content, some regeneration of sodium hydroxide was noted, and regeneration was reversed when the anode to cathode ratio was reduced to less than 12 to 1. After 2 hours, as indicated by the increase in manganate, decrease in permanganate, and decrease in sodium hydroxide content compared to the 1 hour mark, degeneration was occurring. This defect was reversed after 4 hours when the voltage was returned to 8 volts.

In the run corresponding to the third block of data in table 3, the temperature of the bath was reduced somewhat and the voltage was slightly reduced. The anode to cathode ratio remained 12:1. In this run, regeneration of permanganate, degeneration of manganate, and very slight regeneration of hydroxide were observed.

For the last block of data in table 3, the previous bath was diluted 1/3 with deionized water and the temperature of the bath during electrolysis was further reduced. Under these conditions, sodium hydroxide was regenerated, the permanganate concentration increased substantially, and the manganate concentration diminished substantially, thus illustrating substantially better results than before. After 2 hours the anode and cathode potentials were measured. The anode potential was 0.6 volts versus SCE and the cathode potential was minus 4 volts versus SCE, again indicating a voltage drop outside the cell. In this run a large amount of hydrogen gas was evolved at the cathode, thus indicating the electrolysis of water in competition with reformation of manganate ion at the cathode.

## EXAMPLE 3

A fresh bath was made up containing 160 grams per liter of permanganate (as sodium permanganate) and 60 grams per liter of sodium hydroxide in deionized water. This is a standard oxidizing bath. To increase the manganate and decrease the permanganate, representing degeneration of the bath during use, it was first electrolyzed at an anode to cathode ratio of 5 to 1 and a voltage difference of 1 to 2 volts. This provided only a very slow change in the amount of permanganate present. Next, the solution was further depleted by placing ten 3 inch square (58 $cm^2$) epoxy resin panels in the bath and heating it for several hours. The resulting bath had the composition shown in the top row of data in table 4. The anode had an

area of 0.75 square feet (697 $cm^2$) and the cathode had an area of 4 square inches (25.8 $cm^2$), resulting in an anode to cathode ratio of about 27:1.

The bath was electrolyzed under the conditions and with the results shown in Table 4. At 4 hours the manganate was reduced from 28 grams per liter (above the usual specification for such baths) to 14 grams per liter (within specifications). At the same time the permanganate was increased from 135 grams per liter to 150 grams per liter and the concentration of sodium hydroxide increased from 53 to 59 grams per liter. This example thus shows the potential for regenerating permanganate and sodium hydroxide under bath conditions approximating those of a commercial bath which has been depleted due to etching.

EXAMPLE 4 (Potassium permanganate bath)

A 3.5 liter permanganate oxidizing bath was prepared in a glass beaker. The bath contained 60 grams per liter of potassium permanganate and 40 grams per liter of sodium hydroxide in deionized water. The bath was depleted of permanganate by using it to etch epoxy resin coupons until it reached the starting composition set forth in Table 5. A nickel plated anode as previously described, having a wetted area of 0.75 square feet (687 $cm^2$), was used. The cathode was a stainless steel plate having a wetted area of 0.05 square feet (46 $cm^2$). The anode to cathode ratio was thus 15:1. The cell was stirred during regeneration, as before. The progress and results of regeneration arc set forth in table 5. As indicated by table 5, the conversion of manganate to permanganate ion was substantial and it appeared that hydroxide ion was also generated. Example 4 illustrates that potassium permanganate based baths can also be regenerated using the present method.

Examples 5 - 17

These examples were carried out similarly to the previous ones, but the anode/cathode ratio, and in some cases other parameters, were changed to show their influence on regeneration of permanganate. Also, the experiment was carried out on a larger scale. The current used was about 24 amperes in each example.

Table 6 reports the data collected in these examples, arranged in order of the anode-to-cathode wetted area ratios. In this table, temperature and the individual anode and cathode potentials (versus a saturated calomel electrode) are reported, as well as the parameters reported in previous examples.

For each example, a linear regression estimate was made of the changes in manganate, permanganate, and sodium hydroxide concentrations per unit time. The difference between change of permanganate and change of manganate per unit time was also calculated, and is a measure of rate of conversion of manganate into permanganate. A positive value of this difference indicates that permanganate was being regenerated. All these values for Examples 5 - 17 are reported in Table 7.

In two groups of examples, specifically Examples 5 and 6 and Examples 12 - 17, the same anode to cathode ratio is used, yet the net regeneration of permanganate (dPerm/dt-dMan/dt) is not identical in each case. This shows the influence of other parameters reported in Tables 6 and 7 on the rate of regeneration. Nonetheless, the tables show that substantial regeneration of permanganate to manganate is possible at anode to cathode wetted area ratios greater than or equal to 6.45:1. Regeneration at a substantial rate is possible at higher ratios, particularly 32.25:1 and above.

A further analysis of the data of Table 6 was carried out using X-STAT, a statistical analysis program which employs a linear model to evaluate the importance of each parameter in the permanganate regeneration process. A good correlation was found between the ratio of anode wetted surface area to cathode wetted surface area and the rate of change of permanganate and manganate concentrations.

Other conclusions reached from this data are that regeneration can be carried out over a wide temperature range and that an anode-to-cathode potential difference of at least 4 volts should be maintained during regeneration.

Example 18

A 45 gallon (170 liter) sodium permanganate bath maintained at 160°F (71°C), having the initial concentrations specified in Table 8, was regenerated. The electrode assembly used for regeneration was the electrode assembly of Figures 1 and 2, partially immersed in the bath. The anode:cathode ratio was

21:1. 100 amperes of current were delivered throughout the experiment. The changes in bath concentration and electrolysis conditions are stated in Table 8. Regeneration of permanganate from manganate was clearly demonstrated.

Example 19

The electrode assembly of Example 19 was used to regenerate an 80 gallon (291 liter) permanganate bath over a period of two work days, under the conditions and with the results reported in Table 9. Again, regeneration of permanganate from manganate is clearly demonstrated.

TABLE 1

| Permanganate Baths | | |
|---|---|---|
| Parameter | Bath 1 | Bath 2 |
| temperature | 82 ± 6 °C | 82 ± 6 °C |
| solvent | deionized water | deionized water |
| $MnO_4^{-1}$ | 60 ± 20 g/l | 160 ± 30 g/l |
| $MnO_4^{-2}$ | less than 40 g/l | less than 40 g/l |
| NaOH | 40 ± 20 g/l | 60 ± 20 g/l |
| cations | Na and K | Na only |

Table 2

| (Comparative) (Example 1) | | | | | | |
|---|---|---|---|---|---|---|
| Time (hrs) | $MnO_4^{-2}$ (g/l)[1] | $MnO_4^{-1}$ (g/l)[2] | NaOH (g/l)[3] | I[4] (amps) | E[5] (volts) | A/C ratio[6] |
| 0 | 34 | 114 | 68 | 10 | 1.5v | 1:1 |
| 2 | 30 | 115 | 69 | 10 | 1.5v | 1:1 |
| 3 | 29 | 115 | 68 | 10 | 1.5v | 1:1 |
| 4 | 29 | 114 | 69 | 10 | 1.5v | 1:1 |
| 0 | 32 | 104 | 160 | 10 | 1.5v | 1:1 |
| 0.83 | 41 | 95 | 157 | 10 | 1.5v | 1:1 |
| 2 | 24 | 102 | 157 | 10 | 1.5v | 1:1 |
| 3 | 24 | 105 | 157 | 10 | 1.5v | 1:1 |
| 4 | 32 | 105 | 158 | 10 | 1.5v | 1:1 |
| 5 | 30 | 98 | 158 | 10 | 1.5v | 1:1 |

1. grams of manganate ion per liter of solution.
2. grams of permanganate ion per liter of solution.
3. grams sodium hydroxide per liter of solution.
4. current through cell (amperes).
5. potential difference between anode and cathode (measured at rectifier)
6. ratio of wetted areas of anode and cathode.

Table 3

| (Example 2) | | | | | | | |
|---|---|---|---|---|---|---|---|
| Time (hrs) | Temp °C | $MnO_4^{-2}$ (g/l) | $MnO_4^{-1}$ (g/l) | NaOH (g/l) | I (Amps) | E (Volts) | A/C Ratio |
| 0 | 82° | 83 | 50 | 162 | 14 | 5.8 | 15:1 |
| 1 | 82° | 35 | 75 | 154 | 14 | 5.8 | 15:1 |
| 2 | 82° | 48 | 85 | 169 | 14 | 5.8 | 15:1 |
| 3 | 82° | 52 | 85 | 170 | 14 | 5.8 | 15:1 |
| 4 | 82° | 40 | 88 | 151 | 14 | 5.8 | 15:1 |
| 5.5 | 82° | 58 | 71 | 157 | 14 | 5.8 | 15:1 |
| 0 | 71 | 53 | 67 | 143 | 14 | 8 | 12:1 |
| 1 | 82 | 49 | 71 | 146 | 6 | 2 | 12:1 |
| 2 | 82 | 64 | 64 | 145 | 14 | 8 | 12:1 |
| 3 | 58 | 67 | 67 | 155 | 14 | 8 | 12:1 |
| 4 | 88 | 54 | 70 | 153 | -- | -- | 12:1 |
| 5 | 52 | 71 | 71 | 158 | 14 | 8 | 12:1 |
| 0 | 50 | 52 | 62 | 146 | 14 | 7 | 12:1 |
| 1 | 70 | 44 | 71 | 148 | 13 | 6 | 12:1 |
| 2 | 81 | 38 | 77 | 147 | 13 | 6 | 12:1 |
| 3 | 73 | 35 | 79 | 148 | 13 | 6 | 12:1 |
| 4 | 72 | 36 | 79 | 148 | 13 | 6 | 12:1 |
| 0 | 52 | 47 | 28 | 120 | 13 | 6 | 12:1 |
| 1 | 60 | 29 | 48 | 129 | 13 | 6 | 12:1 |
| 2 | 62 | 20 | 51 | 126 | -- | -- | 12:1 |
| 3.5 | 66 | 17 | 58 | 134 | -- | -- | 12:1 |

Table 4

| (Example 3) | | | | | | | |
|---|---|---|---|---|---|---|---|
| Time (hrs) | Temp °C | $MnO_4^{-2}$ (g/l) | $MnO_4^{-1}$ (g/l) | NaOH (g/l) | I (amps) | E (volts) | A/C ratio |
| 0 | 57 | 28 | 135 | 53 | 13 | 7.5 | 27:1 |
| 1 | 81 | 22 | 145 | 56 | 13 | 7 | 27:1 |
| 2 | 78 | 18 | 148 | 57 | 13 | 7 | 27:1 |
| 4 | 80 | 14 | 150 | 59 | 13 | 7 | 27:1 |
| 6 | 77 | 15 | 143 | 56 | 13 | 7 | 27:1 |

Table 5

| (Example 4) | | | | | | | |
|---|---|---|---|---|---|---|---|
| Time (hrs) | Temp °C | $MnO_4^{-2}$ (g/l) | $MnO_4^{-1}$ (g/l) | NaOH (g/l) | I (amps) | E (volts) | A/C ratio |
| 0 | 74 | 23 | 28 | 41 | 12 | 8 | 15:1 |
| 1 | 74 | 11 | 40 | 45 | 12 | 8 | 15:1 |
| 2 | 73 | 7 | 43 | 45 | 12 | 8 | 15:1 |
| 3 | 74 | 6 | 43 | 45 | 12 | 8 | 15:1 |

## Table 6

**Example 5: A/C Ratio of 1:1**

| Time (hrs) | Temp °C | $MnO_4^{-2}$ (g/l) | $MnO_4^{-1}$ (g/l) | NaOH (g/l) | Ea[1] | Ec[2] | E' (total) |
|---|---|---|---|---|---|---|---|
| 0 | 66 | 31 | 132 | 65 | 1.10 | -2.43 | 3.6 |
| 1 | 69 | 32 | 131 | 65 | 1.12 | -3 | 4.06 |
| 3 | 70 | 31 | 133 | 62 | 1.16 | -3.1 | 4.23 |

## Table 6 (Continued)

### Example 6: A/C Ratio of 1:1

| Time (hrs) | Temp °C | $MnO_4^{-2}$ (g/l) | $MnO_4^{-1}$ (g/l) | NaOH (g/l) | $E_a^1$ | $E_c^2$ | $E^3$ (total) |
|---|---|---|---|---|---|---|---|
| 0 | 81 | 36 | 126 | 67 | 1.04 | -0.95 | 2.46 |
| 1.5 | 87 | 40 | 126 | 66 | 0.59 | -2.7 | 3.76 |
| 2.5 | 83 | 40 | 129 | 68 | 1.07 | -3.08 | 4.03 |

### Example 7: A/C Ratio of 6.45:1

| Time (hrs) | Temp °C | $MnO_4^{-2}$ (g/l) | $MnO_4^{-1}$ (g/l) | NaOH (g/l) | $E_a^1$ | $E_c^2$ | $E^3$ (total) |
|---|---|---|---|---|---|---|---|
| 0 | 82 | 40 | 119 | 61 | 1.27 | -3.95 | 5.24 |
| 1.5 | 80 | 38 | 120 | 64 | 1.54 | -4.32 | 5.85 |
| 3 | 80 | 40 | 126 | 68 | 1.6 | -4.69 | 5.35 |

### Example 8: A/C Ratio of 9:1

| Time (hrs) | Temp °C | $MnO_4^{-2}$ (g/l) | $MnO_4^{-1}$ (g/l) | NaOH (g/l) | $E_a^1$ | $E_c^2$ | $E^3$ (total) |
|---|---|---|---|---|---|---|---|
| 0 | 88 | 23 | 165 | 58 | 0.365 | -2.15 | 2.5 |
| 2.67 | 83 | 35 | 163 | 53 | 0.412 | -2.17 | 2.6 |
| 3.67 | 83 | 31 | 166 | 54 | 0.406 | -2.2 | 2.6 |
| 5.6 | -- | 31 | 160 | 52 | -- | -- | -- |

Table 6 (Continued)

Example 9: A/C Ratio of 15:1

| Time (hrs) | Temp °C | $MnO_4^{-2}$ (g/l) | $MnO_4^{-1}$ (g/l) | NaOH (g/l) | $E_a^1$ | $E_c^2$ | $E^3$ (total) |
|---|---|---|---|---|---|---|---|
| 0 | 68 | 24 | 164 | 55 | 0.49 | -2.85 | 3.65 |
| 1 | 74 | 22 | 169 | 56 | 0.445 | -2.75 | 3.15 |
| 3 | 74 | 22 | 167 | 57 | 0.432 | -2.73 | -- |

Example 10: A/C Ratio of 32.25:1

| Time (hrs) | Temp °C | $MnO_4^{-2}$ (g/l) | $MnO_4^{-1}$ (g/l) | NaOH (g/l) | $E_a^1$ | $E_c^2$ | $E^3$ (total) |
|---|---|---|---|---|---|---|---|
| 0 | 74 | 43 | 129 | 68 | 0.64 | -2.85 | 3.58 |
| 1 | 72 | 28 | 142 | 72 | -- | -- | -- |
| 2 | 71 | -- | -- | -- | 0.65 | -3.24 | 3.9 |
| 3 | -- | 32 | 143 | 73 | 0.66 | -3.65 | 4.12 |
| 4 | 68 | 26 | 150 | 73 | 0.64 | -3.69 | 4.26 |

Example 11: A/C Ratio of 36.7:1

| Time (hrs) | Temp °C | $MnO_4^{-2}$ (g/l) | $MnO_4^{-1}$ (g/l) | NaOH (g/l) | $E_a^1$ | $E_c^2$ | $E^3$ (total) |
|---|---|---|---|---|---|---|---|
| 0 | 72 | 36 | 129 | 64 | 0.61 | -3.72 | 4.3 |
| 1 | 72 | 35 | 131 | 65 | -- | -- | -- |
| 2 | -- | 32 | 135 | 68 | 0.74 | -4.04 | 4.84 |
| 3.5 | 71 | 31 | 143 | 69 | 0.72 | -6.38 | 7.16 |

## Table 6 (Continued)

### Example 12: A/C Ratio of 68.4:1

| Time (hrs) | Temp °C | $MnO_4^{-2}$ (g/l) | $MnO_4^{-1}$ (g/l) | NaOH (g/l) | $E_a^1$ | $E_c^2$ | $E^3$ (total) |
|---|---|---|---|---|---|---|---|
| 0 | 89 | 37 | 125 | 38 | 0.53 | -3.17 | 3.69 |
| 1 | 86 | 29 | 138 | 41 | 0.49 | -3.26 | 3.76 |
| 2 | 90 | 16 | 143 | 46 | 0.52 | -3.22 | 3.76 |
| 3.5 | 91 | 17 | 150 | 46 | 0.51 | -3.51 | 3.89 |
| 4.5 | 91 | 18 | 159 | 47 | 0.52 | -3.5 | 4.2 |

### Example 13: A/C Ratio of 68.4:1

| Time (hrs) | Temp °C | $MnO_4^{-2}$ (g/l) | $MnO_4^{-1}$ (g/l) | NaOH (g/l) | $E_a^1$ | $E_c^2$ | $E^3$ (total) |
|---|---|---|---|---|---|---|---|
| 0 | 86 | 25 | 142 | 71 | 0.49 | -3.22 | 3.72 |
| 1 | 81 | 32 | 143 | 69 | 0.47 | -3.47 | 3.37 |
| 2 | 80 | 29 | 146 | 71 | 0.54 | -3.6 | 4.15 |
| 3.5 | 80 | 25 | 152 | 74 | 0.52 | -4 | 4.5 |

### Example 14: A/C Ratio of 68.4:1

| Time (hrs) | Temp °C | $MnO_4^{-2}$ (g/l) | $MnO_4^{-1}$ (g/l) | NaOH (g/l) | $E_a^1$ | $E_c^2$ | $E^3$ (total) |
|---|---|---|---|---|---|---|---|
| 0 | 67 | 26 | 160 | 53 | 0.453 | -3.7 | 4.17 |
| 1.75 | 71 | 20 | 169 | 55 | 0.424 | -3.7 | 4.24 |
| 3 | 72 | 23 | 170 | 53 | 0.416 | -3.7 | 4.16 |
| 4 | 71 | 12 | 176 | 57 | -- | -- | -- |

Table 6 (Continued)

Example 15: A/C Ratio of 68.4:1

| Time (hrs) | Temp °C | $MnO_4^{-2}$ (g/l) | $MnO_4^{-1}$ (g/l) | NaOH (g/l) | $Ea^1$ | $Ec^2$ | $E^3$ (total) |
|---|---|---|---|---|---|---|---|
| 0 | 73 | 29 | 159 | 49 | 0.535 | -3.7 | 4 |
| 1 | 74 | 20 | 166 | 51 | 0.525 | -3.5 | 4 |
| 3 | 70 | 12 | 173 | 54 | 0.589 | -3.6 | 4.2 |
| 4.5 | 72 | 11 | 177 | 54 | 0.597 | -3.57 | 4.17 |

Example 16: A/C Ratio of 68.4:1

| Time (hrs) | Temp °C | $MnO_4^{-2}$ (g/l) | $MnO_4^{-1}$ (g/l) | NaOH (g/l) | $Ea^1$ | $Ec^2$ | $E^3$ (total) |
|---|---|---|---|---|---|---|---|
| 0 | 26 | 14 | 165 | 51 | 0.8 | -6.2 | 6.9 |
| 1 | 32 | 14 | 170 | 49 | 0.79 | -5 | 5.86 |
| 2 | 38 | 8 | 173 | 52 | 0.71 | -4.9 | 5.66 |
| 4.5 | 48 | 8 | 177 | 50 | 0.65 | -4.5 | 5.15 |

Example 17: A/C Ratio of 68.4:1

| Time (hrs) | Temp °C | $MnO_4^{-2}$ (g/l) | $MnO_4^{-1}$ (g/l) | NaOH (g/l) | $Ea^1$ | $Ec^2$ | $E^3$ (total) |
|---|---|---|---|---|---|---|---|
| 0 | 27 | 24 | 140 | 43 | 0.72 | -5.9 | 6.67 |
| 1 | 36 | 24 | 143 | 42 | 0.54 | -5.4 | 6 |
| 2.5 | 42 | 11 | 152 | 47 | 0.64 | -4.8 | 5.56 |
| 4 | 47 | 8 | 158 | 47 | -- | -- | 5.22 |

1. anode voltage (vs. saturated calomel electrode)
2. cathode voltage (vs. saturated calomel electrode)
3. Ea - Ec

Table 7

| Example | dPerm/dt[1] | dMan/dt[2] | dOH/dt[3] | (dPerm/dt-dMan/dt)[4] | A/C Ratio |
|---|---|---|---|---|---|
| 5 | 0.43 | -0.07 | -1.07 | 0.50 | 1:1 |
| 6 | 1.11 | 1.68 | 0.32 | -0.58 | 1:1 |
| 7 | 2.33 | 0.00 | 2.33 | 2.33 | 6.45:1 |
| 8 | -0.72 | 1.43 | -1.05 | -2.15 | 9:1 |
| 9 | 0.71 | -0.57 | 0.64 | 1.29 | 15:1 |
| 10 | 4.30 | -3.00 | 1.10 | 7.30 | 32.25:1 |
| 11 | 4.07 | -1.53 | 1.53 | 5.61 | 38.7:1 |
| 12 | 6.88 | -4.20 | 1.95 | 11.08 | 68.4:1 |
| 13 | 2.93 | -0.43 | 1.03 | 3.36 | 68.4:1 |
| 14 | 3.72 | -2.82 | 0.71 | 6.54 | 68.4:1 |
| 15 | 3.87 | -3.90 | 1.15 | 7.76 | 68.4:1 |
| 16 | 2.51 | -1.47 | -0.07 | 3.99 | 68.4:1 |
| 17 | 4.69 | -4.59 | 1.29 | 9.28 | 68.4:1 |

1. change in permanganate concentration (g/l) per hour
2. change in manganate concentration (g/l) per hour
3. change in sodium hydroxide concentration (g/l) per hour
4. net regeneration rate (change in permanganate per hour, minus change in manganate per hour

Table 8

| Example 18 | | | | | | |
|---|---|---|---|---|---|---|
| Time (hrs) | $MnO_4^{-2}$ (g/l) | $MnO_4^{-1}$ (g/l) | NaOH (g/l) | $E_a^1$ (volt) | $E_c^2$ (volt) | $E^3$ (volt) |
| 0 | 38 | 129 | 51 | -- | -- | -- |
| 2 | 32 | 136 | 52 | -- | -- | -- |
| 4 | 27 | 139 | 55 | -- | -- | -- |
| 6 | 29 | 135 | 53 | -- | -- | -- |
| 8 | 24 | 143 | 56 | 0.58 | -5.20 | 5.85 |
| 10 | 19 | 148 | 57 | -- | -- | -- |
| 12 | 17 | 150 | 57 | 0.60 | -4.74 | 5.36 |
| 14 | 12 | 153 | 57 | 0.63 | -4.93 | 5.57 |

Table 9

| Example 19 | | | | | | | |
|---|---|---|---|---|---|---|---|
| Time (hrs) | $MnO_4^{-2}$ (g/l) | $MnO_4^{-1}$ (g/l) | NaOH (g/l) | I (amps) | $E_a^1$ (volts) | $E_c^2$ (volts) | $E^3$ (volts) |
| Day 1 (71 °C) | | | | | | | |
| 0 | 37 | 142 | 58 | 100 | -- | -- | -- |
| 2.5 | 36 | 148 | 57 | 100 | 0.54 | -4.77 | 5.31 |
| 5 | 32 | 127 | 48 | 140 | 0.61 | -5.43 | 6.04 |
| 7 | 33 | 126 | 52 | 150 | 0.59 | -5.95 | 6.58 |
| 8.5 | 31 | 131 | 54 | 150 | 0.70 | -5.58 | 6.98 |
| Day 2 (44 °C) | | | | | | | |
| 0 | 31 | 133 | 55 | 150 | 1.05 | -8.00 | 9.16 |
| 2 | 29 | 136 | 56 | 150 | 1.01 | -6.40 | 9.15 |
| 5 | 23 | 143 | 55 | 150 | 1.00 | -6.20 | 9.15 |
| 7.5 | 21 | 144 | 58 | 150 | 1.03 | -6.15 | 8.25 |
| 10 | 20 | 146 | 59 | 150 | 1.02 | -6.11 | 7.22 |
| 12 | 17 | 149 | 60 | 150 | 1.03 | -6.15 | 7.18 |

## Claims

1. A method of generating permanganate in a bath comprising an alkali metal manganate and water, comprising the steps of:

A. immersing an anode (12) and a cathode (14) in said bath, wherein the ratio of the wetted surface area of said anode to the wetted surface area of said cathode is greater than 5:1; and

B. applying a sufficient potential difference between said anode and said cathode to convert manganate to permanganate at said anode and generate hydrogen gas at said cathode.

2. A method according to claim 1, wherein said potential difference is at least 2 volts.

3. A method according to claim 2, wherein said potential difference is at least 4 volts.

4. A method according to any preceding claim, wherein said ratio of surface areas is greater than 12:1.

5. A method according to any preceding claim, comprising the preliminary step of depleting said bath of permanganate by oxidizing an oxidizable material therein.

6. A method according to claim 5, wherein the permanganate depletion and the application of the voltage to the immersed electrodes are conducted simultaneously, thus maintaining substantially constant permanganate and manganate concentrations in said bath.

7. Apparatus for regenerating a permanganate bath, comprising a vessel for receiving a bath and an anode (12) and a cathode (14) connected by a source (44) of electromotive force and having immersible portions disposed within said vessel, wherein the ratio of the immersible area of said anode to the immersible area of said cathode is greater than 5:1.

8. Apparatus according to claim 7 wherein said ratio is greater than 12:1.

9. Apparatus according to claim 7 or claim 8, wherein said vessel has an electrically conductive bath-receiving surface, at least a portion of which defines said immersible portion of said anode (12).

10. Apparatus according to any one of claims 1 to 9, in which said anode and said cathode are disposed within a single cell (10).

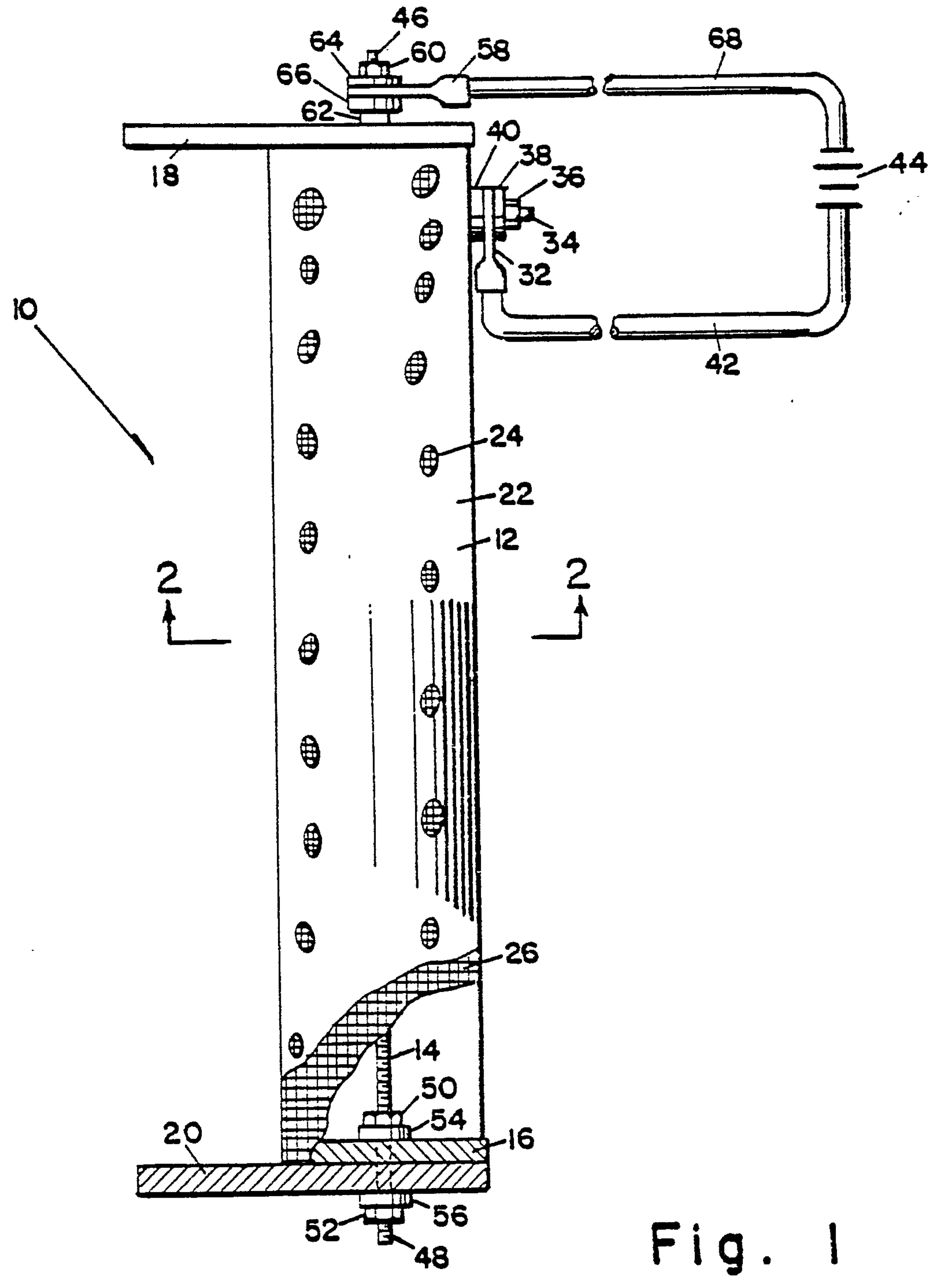
46
64
60
58
68
66
62
40
38
36
44
18
34
32
10
42
24
22
12
2
2
26
14
50
54
20
16
52
56
48

Fig. 1

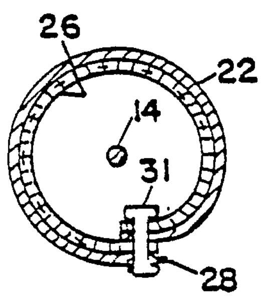
26
22
14
31
28

Fig. 2

European Patent Office

# EUROPEAN SEARCH REPORT

Application Number

EP 90 30 3406

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| P,X | US-A-4 859 300 (T.E. SULLIVAN et al.) * Claims 1-3; column 3, lines 35-39 * --- | 1-10 | C 23 C 18/22<br>C 23 C 18/16 |
| Y | EP-A-0 291 445 (SCHERING A.G.) * Claims 1-7; column 2, lines 23-30 * --- | 1-10 | |
| Y | DE-A-2 514 184 (NIPPON CHEMICAL IND. CO.) * Claim 1; page 9, paragraph 2; example 1 * --- | 1-10 | |
| A | GB-A-1 135 219 (VEB, ELEKTROCHEMISCHES KOMBINAT BITTERFELD) * Claims 1-5 * ----- | 1,7 | |

TECHNICAL FIELDS SEARCHED (Int. Cl.5)

C 23 C
C 23 F
C 01 G
C 25 B

The present search report has been drawn up for all claims

| Place of search | Date of completion of the search | Examiner |
|---|---|---|
| THE HAGUE | 25-07-1990 | DE ANNA P.L. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document